# EUROPEAN PATENT SPECIFICATION

(11) **EP 2 742 539 B1**
(45) Date of publication and mention of the grant of the patent: **02.03.2016**
(21) Application number: 12822137.1
(22) Date of filing: 10.08.2012
(51) Int. Cl.: H01L 31/18, H01L 31/042, C23C 14/34, C23C 14/35, H01J 37/34, H01J 37/32

(54) **SPUTTERING SYSTEMS FOR LIQUID TARGET MATERIALS**
SPUTTERSYSTEME FÜR FLÜSSIGE TARGETSTOFFE
SYSTÈMES DE PULVÉRISATION CATHODIQUE POUR MATÉRIAUX CIBLES LIQUIDES

(30) Priority: 11.08.2011 US 201161522621 P
(43) Date of publication of application: 18.06.2014
(73) Proprietor: Nuvosun, Inc., Milpitas, CA 95035 (US)
(72) Inventor: HOLLARS, Dennis, R., San Jose, CA 95124-1103 (US)
(74) Representative: Beck Greener
(86) International application number: PCT/US2012/050418
(87) International publication number: WO 2013/023173

(56) References cited:
- WO-A1-2010/120792
- US-A- 5 211 824
- US-A- 5 507 931
- US-A1- 2002 092 766
- US-A1- 2002 108 847

## Description

### BACKGROUND

Thin film solar cells formed of copper indium gallium (di)selenide (CIGS) as the absorber layer are becoming a popular solution for at least some cost competitive solar installations. One of the more economically attractive methods of manufacturing these cells utilizes wide web sputtering of the component materials, or alloys of those materials, onto thin flexible substrates. The highest laboratory efficiencies for the cells have been shown to occur when the first part of the absorber layer consists of a layer of indium/gallium selenide. This occurs in the first stage of the well known "3-stage" process for CIGS that was developed at the National Renewable Energy Laboratory (NREL) in 1994, and described in U.S. Patent No. 5,441,897 to Noufi et al. ("Method of fabricating high-efficiency Cu(In,Ga)(SeS)2 thin films for solar cells"), issued August 15, 1995, which is entirely incorporated herein by reference. Gallium presents a somewhat unique situation for sputtering since it has a low melting point (29.8°C) and may exist as a liquid under normal sputtering conditions, unless cooling (e.g., cryogenic) steps are taken to keep it in the solid state. Such measures are generally considered to be too inconvenient and too expensive to be useful in a production environment. If indium and gallium are combined to form an alloy, the eutectic phase at 16.5 atomic % indium forms and melts at 15.7°C, making the alloy target extremely difficult to use in any practical way. US 2002/0092766 A1 discloses sputter deposition apparatus for depositing a film onto a substrate including a surrogate rotating magnetron including an internal magnet and a wall thickness that permits a fringe magnetic field to support an electron cyclotron resonance.

### SUMMARY

This disclosure provides systems and methods for sputter deposition of materials (e.g., metals) to make thin films whose target components and/or alloys may inconveniently exist in liquid phase in conventional sputtering applications. In particular it describes a way to deposit an indium-gallium alloy thin film from metal targets for use in solar cells. The setup circumvents the formation of segregated liquid phases that form if the metals are combined into a single alloy target.

An aspect of the invention provides a setup for a sputter deposited coating made from a liquid metal or liquid metal alloy target material.

Another aspect of the invention provides a setup to sputter deposit a coating from a liquid metal or liquid metal alloy target material which is highly efficient in terms of target material utilization.

Another aspect of the invention provides a reactively deposited alloy coating setup using a planar liquid gallium target and a rotatable indium target that may be accomplished conveniently and economically by magnetron sputtering.

An aspect of the invention provides a sputtering system for depositing a film on a substrate, comprising a magnetron assembly comprising a rotatable magnetron adjacent to a horizontal magnetron, and one or more shields forming a chamber between the rotatable magnetron and the horizontal magnetron. The horizontal magnetron can be configured to contain a liquid target having a first material and provide a material flux having the first material directed towards the rotatable magnetron. The rotatable magnetron can be configured to rotate a solid target having a second material in relation to the horizontal magnetron and provide a material flux having the first and second materials directed towards a substrate in view of the rotatable magnetron.

Another aspect of the invention provides a sputtering system for depositing a film on a substrate. The system comprises a horizontal magnetron that can be adapted to contain a liquid target having a first material and provide a material flux having the first material, and a rotatable magnetron in proximity to the horizontal planar magnetron. The rotatable magnetron can be adapted to contain a solid target having a second material and provide a material flux having the first and second materials directed towards a substrate in view of the rotatable magnetron. The sputtering system can further include one or more shields forming a chamber between the horizontal magnetron and the rotatable magnetron.

Another aspect of the invention provides a method for sputtering an alloy film on a substrate. The method comprises generating, with the aid of a sputtering system, a material flux comprising a first material and a second material, and exposing the substrate to the material flux. The sputtering system can be as described above or elsewhere herein. In some examples, the sputtering system comprises a rotatable magnetron adjacent to a horizontal magnetron, and one or more shields that form a chamber between the rotatable magnetron and the horizontal magnetron. The horizontal magnetron contains a liquid target having the first material, and is configured to provide a flux of the first material towards the rotatable magnetron, and the rotatable magnetron rotates a solid target having the second material in relation to the horizontal magnetron and is configured to provide a flux of the first and second materials towards the substrate in view of the rotatable magnetron.

Additional aspects and advantages of the present disclosure will become readily apparent to those skilled in this art from the following detailed description, wherein only illustrative embodiments of the present disclosure are shown and described. As will be realized, the present disclosure is capable of other and different embodiments, and its several details are capable of modifications in various obvious respects, all without departing from the disclosure. Accordingly, the drawings and description are to be regarded as illustrative in nature, and not as restrictive.

### INCORPORATION BY REFERENCE

All publications, patents, and patent applications mentioned in this specification are herein incorporated by reference to the same extent as if each individual publication, patent, or patent application was specifically and individually indicated to be incorporated by reference.

### BRIEF DESCRIPTION OF THE DRAWINGS

The novel features of the invention are set forth with particularity in the appended claims. A better understanding of the features and advantages of the present invention will be obtained by reference to the following detailed description that sets forth illustrative embodiments, in which the principles of the invention are utilized, and the accompanying drawings of which:
FIG. 1a is a schematic cross sectional side view of a planar magnetron assembly for sputtering a liquid metal target material.
FIG. 1b is a schematic cross sectional side view of a dual planar magnetron assembly for co-sputtering with at least one liquid metal target.
FIG. 2 is a schematic cross sectional side view of a planar magnetron setup for sputtering a liquid metal target material onto a cylindrical rotatable magnetron with a solid metal target material.
FIG. 3 is a schematic cross sectional side view of a sputtering system having the magnetron assembly similar to that shown in FIG. 2. The sputtering system of FIG. 3 is adapted for sputtering liquid gallium onto a rotatable indium target to produce a mixed gallium/indium film that is partially or fully reacted with a selenium or sulfur vapor for use in a copper indium gallium diselenide (CIGS) solar cell.

### DETAILED DESCRIPTION

While various embodiments of the invention have been shown and described herein, it will be obvious to those skilled in the art that such embodiments are provided by way of example only. Numerous variations, changes, and substitutions may occur to those skilled in the art without departing from the invention. It should be understood that various alternatives to the embodiments of the invention described herein may be employed.

The term "flux," as used herein, generally refers to the flow of a material. Flux in some cases is the flow rate of a material per unit area.

### Sputtering systems

An aspect of the invention provides a sputtering system for depositing a film on a substrate. The film may be a metallic or metallic alloy film. The sputtering system comprises a magnetron assembly comprising a rotatable magnetron adjacent to a horizontal magnetron and one or more shields forming a chamber between the rotatable magnetron and the horizontal magnetron. The horizontal magnetron can be configured to contain a liquid target having a first material and provide a material flux having the first material that is directed towards the rotatable magnetron. The rotatable magnetron can be configured to rotate a solid target having a second material in relation to the horizontal magnetron and provide a material flux having the first and second materials that is directed towards a substrate in view of the rotatable magnetron.

The first material can have a first melting point and the second material can have a second melting point that is higher than the first melting point. In some cases, during operation, the first material is a liquid and the second material is a solid. In an example, the first material is gallium and the second material is indium or copper.

In some configurations, the rotatable magnetron is at least partly cylindrical in shape. In some cases, the rotatable magnetron is substantially cylindrical in shape.

The horizontal magnetron can be configured to contain another liquid having a third material. The third material may have a third melting point, and the third melting point can be lower than the second melting point of the second material. In an example, the third material is gallium. In another example, the third material is cesium or mercury.

The horizontal magnetron can be configured to provide a flux of the first material in the chamber. The flux of the first material can include one or more atoms of the first material, including neutral and excited species (e.g., anions, cations, radicals) of the first material.

The sputtering system can include another (or second) horizontal magnetron adjacent to the horizontal magnetron. The second horizontal magnetron can be configured to provide a flux of a third material in the chamber.

The sputtering system may include another (or second) magnetron assembly adjacent to the magnetron assembly. The second magnetron assembly can be configured to provide a flux of a third material towards the substrate. The magnetron assemblies can be enclosed in another chamber having an opening adapted to expose the substrate.

The sputtering system can include a source of additional materials adjacent to one or more magnetron assemblies. In some examples, the additional material is sulfur or selenium. In some examples, the first material is gallium, the second material is indium or copper, and the third material is copper or indium.

The rotatable magnetron assembly can include a support member adapted to rotate the solid target in relation to the horizontal magnetron. The horizontal magnetron can include a backing plate configured to hold a solid or liquid target. In some examples, the backing plate has a container that holds a liquid target.

The horizontal magnetron and the rotatable magnetron are each configured to supply a magnetic field into the respective targets of the horizontal magnetron and the rotatable magnetron. A magnetic field can be supplied with the aid of a magnetic material, such as a ferromagnetic material. Ferromagnetic materials include iron, nickel, cobalt, rare earth metals, and combinations thereof. Alternatively, a magnetic field can be supplied with the aid of an electromagnet. In some examples, an electromagnet comprises a wire would around a support member, and a magnetic field is generated upon the flow of electrons through the wire.

During operation, the horizontal magnetron operates at a temperature at or above the melting point of the first material and the rotatable magnetron operates a temperature below the melting point of the second material. In an example, the first material is gallium and the second material is indium. The target of the horizontal magnetron operates at a temperature at or above about 29.77°C and the target of the rotatable magnetron operates at a temperature below about 156.6°C.

The rotatable magnetron can rotate at a rate between about 1revolution per minute (rpm) and 50 rpm, or between about 10 rpm and 30 rpm. In some examples, during operation the horizontal magnetron is configured to operate at a direct current (DC) power input from about 1 to 2 kW/foot of target material (e.g., gallium), and the rotatable magnetron is configured to operate at a DC power input from about 3 to 4 kW/foot of target material (e.g., indium).

Exemplary magnetron assemblies, systems and methods for use are provided in U.S. Patent No. 4,298,444 to Chahroudi ("Method for multilayer thin film deposition"), and U.S. Patent No. 6,974,976 to Hollars ("Thin-film solar cells"), both of which are entirely incorporated herein by reference.

Reference will now be made to the figures, wherein like numerals refer to like parts throughout. It will be appreciated that the figures and features therein are not necessarily drawn to scale.

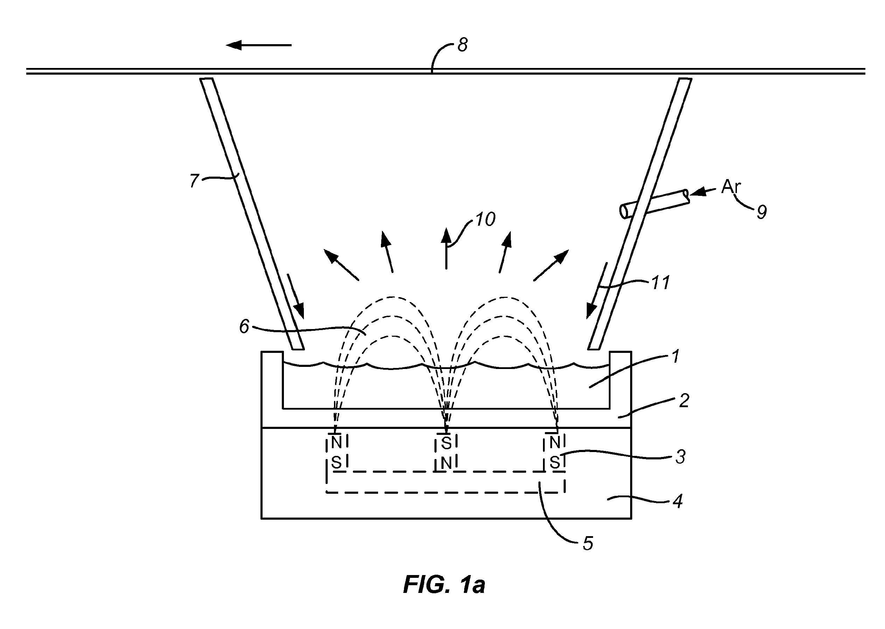

Gallium, mercury, cesium, and some low melting point metal alloys can be sputtered from their liquid phase using conventional rectangular or circular planar magnetrons as long as the apparatus is kept horizontal, or level, so the liquid metal will not spill, or overly accumulate in one region because of a slight tilt. FIG. 1a shows a horizontal magnetron assembly (also "magnetron" herein) that may be employed in such a setup for a liquid metal target. The horizontal magnetron assembly may be a rectangular magnetron, which can be arbitrarily long in the direction perpendicular to the cross section, depending upon the width of the substrate that is to be coated, while a circular magnetron may have the same cross section in any direction. FIG. 1a only shows features of the magnetron that are relevant to the present discussion. For example, water cooling, target insulation, anodes, support members and magnetic field shaping members have been omitted.

Still referring to FIG. 1a, a liquid metal target 1 is held in a boat-like metal "backing plate" 2 that is positioned over an array of magnets 3 that are supported in the magnetron body 4. The magnets 3 can be formed of any material that produces a magnetic field, such as an electromagnet or a ferromagnetic material. A ferromagnetic material can be selected from iron, nickel, cobalt, rare earth metals, and combinations thereof. The backing plate 2 and magnetron body 4 may collectively define at least a portion of a magnetron. The flux from the rear of the magnet array can be shunted by a soft magnetic plate 5 so that the magnetic lines of force 6 penetrate primarily the target region. Shields 7 limit the deposition area on the substrate to those regions nearest to the magnetron. When a gas 9 (e.g., Argon) is added to the region and a voltage is placed on the magnetron, a plasma can be created. The extent of the plasma is limited to regions near the target by the electron trapping action of the magnetic field. Excited argon atoms (e.g., Ar radicals, Ar ions) may bombard the target, and a sputtered flux of target material in the gas phase is ejected to form a coating on the substrate as it passes by the deposition region.

As sputtering proceeds, the level of the liquid target will drop, but the material utilization can be relatively high compared to a solid target that forms a conventional sputtering groove that is concentrated in the central regions of the magnetic field. The surface of liquid metal target 1 has been shown by a wavy line for illustrative purposes.

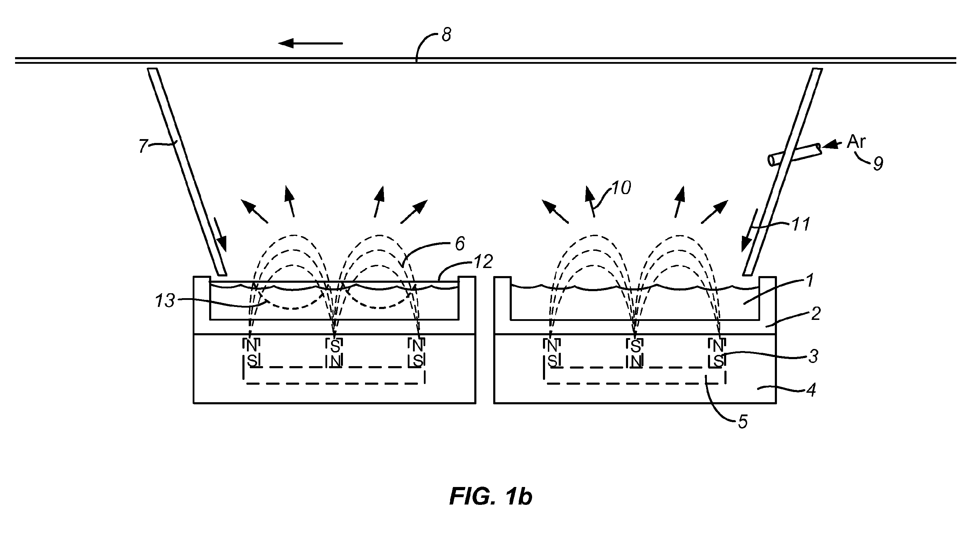

FIG. 1b shows a magnetron assembly having dual version targets of FIG. 1a for co-sputtering two liquid materials, which may be the same liquid materials or different liquid materials (e.g., for making an alloy). As an alternative, one of the targets can be liquid and the other can be solid, or both targets can be solids. FIG. 1b shows a solid target 12 which, after extensive use, may form sputtering grooves depicted by dashed lines 13. In practice, the width of the solid target may be reduced for the same magnetic array dimensions in order to improve the material utilization. This is not illustrated in FIG. 1a.

While FIGS. 1a and 1b show planar magnetron setups modified for sputtering a liquid metal, they also illustrate a liquid recovery system that can improve the utilization of the target material. Referring to FIG 1a or 1b, magnetron body 4 and boat-like backing plate 2 are substantially wider than the array of magnets 3. Additionally, shields 7 are disposed so as to "point" just inside the backing plate, but they do not touch any part of the magnetron (backing plate 2, etc.). In this configuration the shields additionally may be grounded to serve as anodes for targets that are being sputtered by direct current (DC) power. The shields 7 may be vertical rather than angled (or slanted) as shown, the only difference being the width of the flux collection region at the substrate 8. This shield arrangement may permit the sputtered flux that may otherwise accumulate on conventional shields to melt and run (or drip), along the direction of the gravitational acceleration vector, back into the liquid target material as indicated by arrow 11. The temperature of the shields may be kept higher than the liquid target melting point either by the plasma itself or by an external heating unit (not shown).

With respect to the setups (or systems) of FIGs. 1a and 1b, if the coating is only the liquid target material, substrate 8 would have to be kept cold or the coating may melt and subsequently run (or drip) off of the substrate 8. A reactive gas is typically added with or in addition to argon to make a reactive coating (i.e., an oxide, nitride, selenide, etc.). Such a reactive coating (or film) may have a substantially higher melting point, so the target material recovery system would be inoperative. The setup of FIGs. 1a and 1b may therefore pose limitations in some cases. The systems of FIGs. 1a and 1b, in some cases, may not be suitable for materials having melting points that are substantially different.

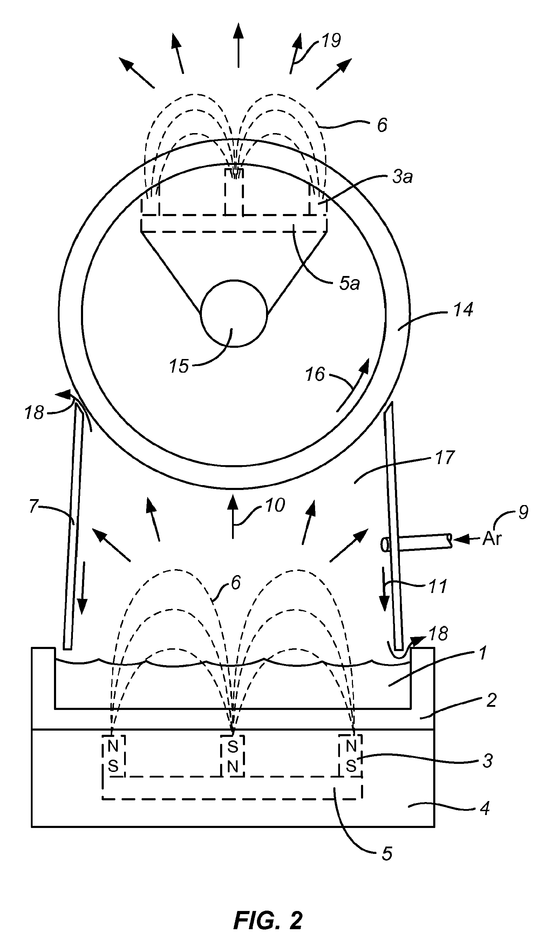

FIG. 2 schematically illustrates a system having a magnetron assembly for sputtering a liquid target onto a solid cylindrical rotatable target. The liquid target may be a metal or metal alloy. The rotatable target 14 may be monolithic if the material is of sufficient mechanical strength, or it can be target material applied to a separate backing tube (tube not shown). The target tube is continuously flushed with a flow of water or other liquid to keep it cool during sputtering (e.g., high power sputtering). A magnet array comprises magnets 3 and a magnetic plate 4. The array in the rotatable target 14 may be similar to the array for the rectangular planar magnetron shown in the magnetron body 4, but may be appropriately modified to fit the circular structure of the target tube. The array is attached to a central support 15, which can include a support member, and is held fixed in position while the target is made to rotate around the fixed magnetic array along the direction indicated by arrow 16. In this setup, the rectangular planar magnetron and the rotatable magnetron along with shields 7 form a chamber-like region 17 which acts as an isolation chamber (or reaction space) for the sputtering of the liquid metal. A sputtering gas (e.g., Ar) provided at inlet 9 fills the region and escapes along small slots 18 formed between the shields 7 and the rotatable target 14 and the magnetron (having backing plate 2 and magnetron body 4). This flushing action of the sputtering gas serves to aid in keeping region 17 clean of any reactive gas or vapor that may be used in conjunction with the sputtering of material from the rotatable target. This advantageously aids in minimizing, if not eliminating, contamination of films formed on the rotatable target 14.

In some embodiments, the liquid 1 comprises one or more materials with a melting point equal to or below the melting point of the material comprised in the rotatable target 14. In an example, the liquid is gallium and the rotatable target 14 is formed of indium.

During operation, sputtered flux 10 from liquid target 1 deposits on the cooled surface of rotatable target 14 where it "freezes" or condenses, or is a thin liquid layer, on the surface of the rotatable target 14. Flux that deposits on heated shields 7 can flow or drip back (generally along the direction of the gravitational acceleration vector) into the liquid target, greatly improving the utilization of the material. The flux that condenses on the surface of rotatable target 14 can be rapidly carried around to the sputtering region where it is sputtered off along with some of the material of target 14 to form a composite flux 19. The composite flux may be directed to a substrate 8 (not shown), onto which it can deposit. In an example, the composite flux comprises gallium and indium. The ratio of liquid material 1 to rotatable target material 14 that is obtained in flux 19 can be controlled by the ratio of the sputtering powers applied to the two magnetrons-i.e., the magnetron having the liquid target 1 and the magnetron having the rotatable target 14. In some cases, if the sputtering rate of liquid material 1 exceeds that of target material 14, only the liquid material may exist as flux 19. In this case target 14 acts only as a transfer unit. As the sputter rate of target 14 starts to exceed that of liquid material 1, an alloy or some mixture of the two materials can appear in flux 19. With an increasing sputter rate of 14 (or a decreasing sputter rate of 1), an increasing proportion of flux 19 can include the target material 14. Accordingly, by adjusting the relative sputtering rates of the two targets (1 and 14), a continuous variation of the composition of flux 19 can be readily obtained.

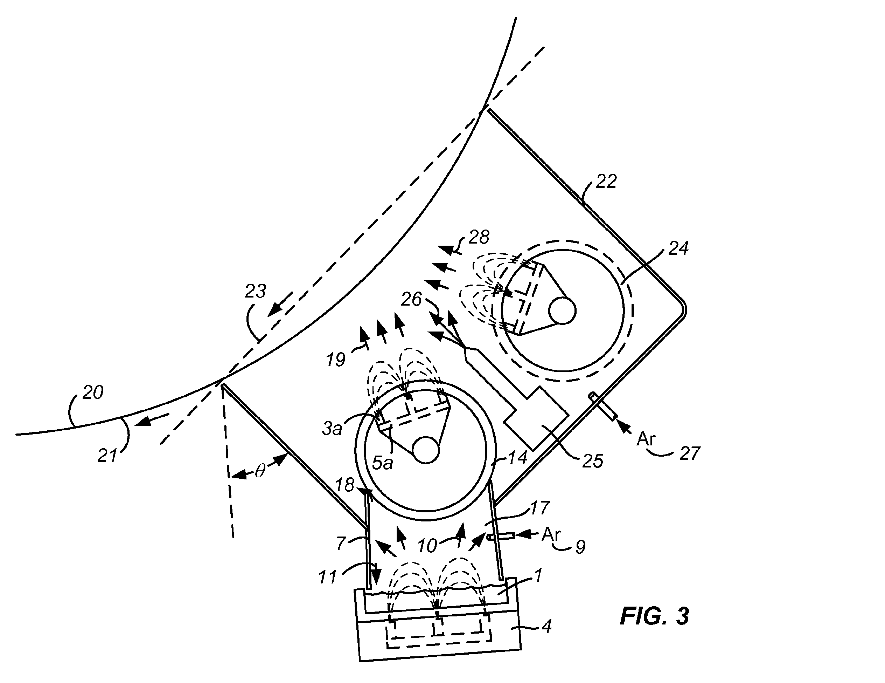

The orientation of the array 3a and 5a is within the rotatable magnetron may be adjusted to provide a flux 19 at an angle that may be suited for various deposition systems (see, e.g., FIG. 3). The array 3a and 5a can be rotated by an angle between about 0° and 90° in relation to the gravitational acceleration vector.

The system of FIG. 2 may be included in various magnetron systems in which multiple targets are employed. FIG. 3 illustrates a system having multiple magnetron assemblies employing multiple targets, in accordance with an embodiment of the invention. The system of FIG. 3 shows a pair of rotatable magnetrons housed in a "mini chamber" 22 which is arranged at an arbitrary angle θ with respect to the gravitational acceleration vector. The mini chamber setup may have features described in U.S. Patent No. 4,298,444 to Chahroudi ("Method for multilayer thin film deposition"), and U.S. Patent No. 6,974,976 to Hollars ("Thin-film solar cells"), both of which are entirely incorporated herein by reference. Substrate 21 is carried past mini chamber 22 on drum 20 to receive the coated material from the magnetrons. Alternatively, the substrate could be held and transported past the coating zone in a linear fashion as indicated by dashed line 23.

In an embodiment, mini chamber 22 is modified to accept the planar magnetron setup of FIG. 2 for sputtering liquid material, which can be held in a level (horizontal) position. The magnetic array 3a and 5a of the system of FIG. 3 is rotated in relation to the array of FIG. 2, which may accommodate the mounting angle and to direct flux 19 appropriately toward the substrate.

For the particular example of depositing an indium/gallium selenide or sulfide film on the substrate, both rotatable targets, 14 and 24, could be pure indium, with liquid target 1 being gallium. To form the mixed metal selenide or sulfide on the substrate, a selenium or sulfur vapor source 25 is provided to emit a flux 26 toward the substrate to react with the arriving metal flux. The substrate temperature can be elevated if needed to help promote or otherwise facilitate the reaction. Injecting a sputtering gas (e.g., argon) 9 into the chamber 17 above the liquid gallium can aid to continually flush the chamber of selenium or sulfur vapor and keep the selenium or sulfur vapor (or both) substantially confined to the chamber 22. Some of the sputtering gas that escapes through 18 serves to provide a portion of the sputtering gas to the chamber 22, but more can be added if needed at another location, such as input 27. This can be desirable as the leakage of argon into the chamber 22 can change with time since the diameter of target 14 can be reduced as sputtering proceeds. By operating the liquid and rotatable magnetrons as described in FIG. 2, in some examples, flux 19 can be a selectable combination of indium and gallium, while flux 28 from target 24 can be indium only. If all three of the targets are sputtered in DC mode, the sputter rate of the targets can be adjusted individually until a desired or otherwise predetermined mix of material fluxes is obtained at the substrate.

In some cases, the two rotatable targets are sputtered in dual alternating current (AC) mode, and the sputter power on each rotatable magnetron can be constrained to be equal. In such a case, the sputtering power on the gallium target can be raised until a desired or otherwise predetermined film composition is obtained. In some examples, the desired film composition is about 25% to 30% gallium.

As an example if the rotatable magnetrons are sputtered by dual AC power, then the sputtering rates of each rotatable magnetron will be the same as mentioned above. To make a coating that is 25% gallium, the gallium target sputtering rate can be adjusted to make flux 19 contain equal amounts of indium and gallium. The resulting mix from all targets can be one part gallium in four parts of total coating.

As another example, the deposition of a copper indium gallium diselenide (CIGS) solar cell absorber layer may require only minor adjustments to the setup described above for the indium/gallium film. One of the rotatable targets, either 14 or 24, that previously were both indium can be changed to copper. For this film the ratio of copper to indium can be controlled independently, so deposition by dual AC operation may not work in some cases unless the sputter rates of the two materials on the rotatable targets are different by the right amount. In some cases, all of the targets are sputtered by DC power with adjustments made to deposit a film having a desired or otherwise predetermined copper, indium, gallium and selenium composition. In some cases, the film has a slightly copper poor composition.

### Example

A magnetron assembly such as that illustrated in FIG. 2 or FIG. 3 comprises a horizontal magnetron with a liquid target comprising gallium, and a rotatable magnetron with a solid target comprising indium. With the rotatable magnetron rotating at a rate of about 15 revolutions per minute, a flux of gallium and indium from the rotatable magnetron is generated by applying DC power to the rotatable magnetron and the horizontal magnetron. DC power of about 1 kW/ft of target material is applied to the horizontal magnetron; DC power of about 3 kW/ft of target material is applied to the rotatable magnetron. A chamber between the magnetrons (e.g., chamber 17 of FIG. 3) is operated under an Argon pressure of about 5 millitorr (mTorr), and a chamber having the magnetron assembly (e.g., chamber 22 of FIG. 3) is operated under an Argon pressure of about 3 mTorr.

It should be understood from the foregoing that, while particular implementations have been illustrated and described, various modifications can be made thereto and are contemplated herein. It is also not intended that the invention be limited by the specific examples provided within the specification. While the invention has been described with reference to the aforementioned specification, the descriptions and illustrations of the preferable embodiments herein are not meant to be construed in a limiting sense. Furthermore, it shall be understood that all aspects of the invention are not limited to the specific depictions, configurations or relative proportions set forth herein which depend upon a variety of conditions and variables. Various modifications in form and detail of the embodiments of the invention will be apparent to a person skilled in the art. It is therefore contemplated that the invention shall also cover any such modifications, variations and equivalents. It is intended that the following claims define the scope of the invention and that methods and structures within the scope of these claims and their equivalents be covered thereby.

## Claims

1. A sputtering system for depositing a film on a substrate (8), comprising:
a magnetron assembly comprising:
a rotatable magnetron adjacent to a horizontal magnetron; and
one or more shields (7) forming a chamber (17) between said rotatable magnetron and said horizontal magnetron,
wherein said horizontal magnetron is configured to contain a liquid target (1) having a first material and provide a material flux (10) having said first material directed towards said rotatable magnetron, and
wherein said rotatable magnetron is configured to rotate a solid target (14) having a second material in relation to said horizontal magnetron and provide a material flux (19) having said first and second materials directed towards a substrate in view of said rotatable magnetron.

2. The sputtering system of Claim 1, wherein said first material has a first melting point and said second material has a second melting point, and wherein said first melting point is lower than said second melting point.

3. The sputtering system of Claim 1 or 2, wherein said rotatable magnetron is at least partly cylindrical in shape.

4. The sputtering system of any of claims 1-3, wherein said horizontal magnetron comprises a backing plate (2) adjacent to a magnetron body (4), and wherein said magnetron body includes one or more magnets (3) and said backing plate is adapted to hold said liquid target.

5. The sputtering system of any of claims 1-4, wherein said rotatable magnetron comprises a support member (15) adapted to rotate said solid target in relation to said horizontal magnetron.

6. The sputtering system of any of claims 1-5, wherein said horizontal magnetron is adapted to contain another liquid having a third material.

7. The sputtering system of any of claims 1-6, wherein said horizontal magnetron is configured to provide a flux of said first material in said chamber.

8. The sputtering system of any of claims 1-7, further comprising another horizontal magnetron adjacent to said horizontal magnetron, wherein said another horizontal magnetron is configured to provide a flux of a third material in said chamber.

9. The sputtering system of any of claims 1-8, further comprising another magnetron assembly adjacent to said magnetron assembly, wherein said another magnetron assembly is configured to provide a flux of a third material towards said substrate.

10. The sputtering system of any of claims 1-9, wherein said magnetron assemblies are enclosed in another chamber (22) having an opening adapted to expose said substrate.

11. The sputtering system of any of claims 1-9, further comprising a source (25) of a fourth material (26) adjacent to said magnetron assembly or said another magnetron assembly.

12. The sputtering system of any of claims 1-11, further comprising a source of a third material adjacent to said magnetron assembly.

13. A method for sputtering an alloy film on a substrate (8), comprising:
(a) generating, with the aid of a sputtering system according to any one of claims 1-12, a material flux comprising a first material and a second material,
wherein said horizontal magnetron contains a liquid target (1) having said first material and provides a flux (10) of said first material towards said rotatable magnetron, and
wherein said rotatable magnetron rotates a solid target (14) having said second material in relation to said horizontal magnetron and provides a flux (19) of said first and second materials towards said substrate in view of said rotatable magnetron; and
(b) exposing said substrate to said material flux.

14. The method of Claim 13, wherein said substrate is exposed to said material flux while said substrate is moved in relation to said sputtering system, or vice versa.

## Patentansprüche

1. Ein Sputtersystem zum Aufbringen eines Films auf einem Substrat (8), beinhaltend:
eine Magnetronanordnung, beinhaltend:
ein drehbares Magnetron neben einem horizontalen Magnetron; und
einen oder mehrere Schilde (7), die zwischen dem drehbaren Magnetron und dem horizontalen Magnetron eine Kammer (17) bilden,
wobei das horizontale Magnetron konfiguriert ist, um ein flüssiges Target (1) mit einem ersten Material zu enthalten und einen Materialfluss (10) bereitzustellen, bei dem das erste Material zu dem drehbaren Magnetron hin gerichtet ist, und
wobei das drehbare Magnetron konfiguriert ist, um ein festes Target (14) mit einem zweiten Material in Bezug auf das horizontale Magnetron zu drehen und einen Materialfluss (19) bereitzustellen, bei dem das erste und zweite Material zu einem Substrat in Sicht des drehbaren Magnetrons hin gerichtet sind.

2. Sputtersystem gemäß Anspruch 1, wobei das erste Material einen ersten Schmelzpunkt aufweist und das zweite Material einen zweiten Schmelzpunkt aufweist und wobei der erste Schmelzpunkt niedriger als der zweite Schmelzpunkt ist.

3. Sputtersystem gemäß Anspruch 1 oder 2, wobei das drehbare Magnetron mindestens teilweise eine zylindrische Form aufweist.

4. Sputtersystem gemäß einem der Ansprüche 1-3, wobei das horizontale Magnetron eine Trägerplatte (2) neben einem Magnetronkörper (4) beinhaltet und wobei der Magnetronkörper einen oder mehrere Magneten (3) umfasst und die Trägerplatte angepasst ist, um das flüssige Target zu halten.

5. Sputtersystem gemäß einem der Ansprüche 1-4, wobei das drehbare Magnetron ein Stützelement (15) beinhaltet, das angepasst ist, um das feste Target in Bezug auf das horizontale Magnetron zu drehen.

6. Sputtersystem gemäß einem der Ansprüche 1-5, wobei das horizontale Magnetron angepasst ist, um eine andere Flüssigkeit mit einem dritten Material zu enthalten.

7. Sputtersystem gemäß einem der Ansprüche 1-6, wobei das horizontale Magnetron konfiguriert ist, um einen Fluss des ersten Materials in der Kammer bereitzustellen.

8. Sputtersystem gemäß einem der Ansprüche 1-7, das ferner ein weiteres horizontales Magnetron neben dem horizontalen Magnetron beinhaltet, wobei das weitere horizontale Magnetron konfiguriert ist, um einen Fluss eines dritten Materials in der Kammer bereitzustellen.

9. Sputtersystem gemäß einem der Ansprüche 1-8, das ferner eine weitere Magnetronanordnung neben der Magnetronanordnung beinhaltet, wobei die weitere Magnetronanordnung konfiguriert ist, um einen Fluss eines dritten Materials zu dem Substrat hin bereitzustellen.

10. Sputtersystem gemäß einem der Ansprüche 1-9, wobei die Magnetronanordnungen in einer weiteren Kammer (22) eingeschlossen sind, welche eine zum Aussetzen des Substrats angepasste Öffnung aufweist.

11. Sputtersystem gemäß einem der Ansprüche 1-9, das ferner eine Quelle (25) eines vierten Materials (26) neben der Magnetronanordnung oder der weiteren Magnetronanordnung beinhaltet.

12. Sputtersystem gemäß einem der Ansprüche 1-11, das ferner eine Quelle eines dritten Materials neben der Magnetronanordnung beinhaltet.

13. Ein Verfahren zum Sputtern eines Legierungsfilms auf ein Substrat (8), beinhaltend:
(a) Erzeugen, mit Hilfe eines Sputtersystems gemäß einem der Ansprüche 1-12, eines Materialflusses, der ein erstes Material und ein zweites Material beinhaltet, wobei das horizontale Magnetron ein flüssiges Target (1) mit dem ersten Material enthält und einen Fluss (10) des ersten Materials zu dem drehbaren Magnetron hin bereitstellt, und
wobei das drehbare Magnetron ein festes Target (14) mit dem zweiten Material in Bezug auf das horizontale Magnetron dreht und einen Fluss (19) des ersten und zweiten Materials zu dem Substrat in Sicht des drehbaren Magnetrons hin bereitstellt; und
(b) Aussetzen des Substrats gegenüber dem Materialfluss.

14. Verfahren gemäß Anspruch 13, wobei das Substrat dem Materialfluss ausgesetzt wird, während das Substrat in Bezug auf das Sputtersystem bewegt wird, oder umgekehrt.

## Revendications

1. Un système de pulvérisation pour déposer un film sur un substrat (8), comprenant :
un ensemble de magnétrons comprenant :
un magnétron rotatif adjacent à un magnétron horizontal ; et
un ou plusieurs écrans (7) formant une chambre (17) entre ledit magnétron rotatif et ledit magnétron horizontal,
dans lequel ledit magnétron horizontal est configuré pour contenir une cible liquide (1) présentant une première matière et fournir un flux de matière (10) présentant ladite première matière en direction dudit magnétron rotatif, et
dans lequel ledit magnétron rotatif est configuré pour faire tourner une cible solide (14) présentant une deuxième matière par rapport audit magnétron horizontal et fournir un flux de matières (19) présentant lesdites première et deuxième matières dirigé en direction d'un substrat en vue dudit magnétron rotatif.

2. Le système de pulvérisation de la revendication 1, dans lequel ladite première matière présente un premier point de fusion et ladite deuxième matière présente un deuxième point de fusion, et dans lequel ledit premier point de fusion est inférieur audit deuxième point de fusion.

3. Le système de pulvérisation de la revendication 1 ou de la revendication 2, dans lequel ledit magnétron rotatif est au moins en partie de forme cylindrique.

4. Le système de pulvérisation de n'importe lesquelles des revendications 1 à 3, dans lequel ledit magnétron horizontal comprend une plaque dorsale (2) adjacente à un corps de magnétron (4), et dans lequel ledit corps de magnétron inclut un ou plusieurs aimants (3) et ladite plaque dorsale est conçue pour renfermer ladite cible liquide.

5. Le système de pulvérisation de n'importe lesquelles des revendications 1 à 4, dans lequel ledit magnétron rotatif comprend un élément de support (15) conçu pour faire tourner ladite cible solide par rapport audit magnétron horizontal.

6. Le système de pulvérisation de n'importe lesquelles des revendications 1 à 5, dans lequel ledit magnétron horizontal est conçu pour contenir un autre liquide présentant une troisième matière.

7. Le système de pulvérisation de n'importe lesquelles des revendications 1 à 6, dans lequel ledit magnétron horizontal est configuré pour fournir un flux de ladite première matière dans ladite chambre.

8. Le système de pulvérisation de n'importe lesquelles des revendications 1 à 7, comprenant en sus un autre magnétron horizontal adjacent audit magnétron horizontal, dans lequel ledit autre magnétron horizontal est configuré pour fournir un flux d'une troisième matière dans ladite chambre.

9. Le système de pulvérisation de n'importe lesquelles des revendications 1 à 8, comprenant en sus un autre ensemble de magnétrons adjacent audit ensemble de magnétrons, dans lequel ledit autre ensemble de magnétrons est configuré pour fournir un flux d'une troisième matière en direction dudit substrat.

10. Le système de pulvérisation de n'importe lesquelles des revendications 1 à 9, dans lequel lesdits ensembles de magnétrons sont encloisonnés dans une autre chambre (22) présentant une ouverture conçue pour exposer ledit substrat.

11. Le système de pulvérisation de n'importe lesquelles des revendications 1 à 9, comprenant en sus une source (25) d'une quatrième matière (26) adjacente audit ensemble de magnétrons ou audit autre ensemble de magnétrons.

12. Le système de pulvérisation de n'importe lesquelles des revendications 1 à 11, comprenant en sus une source d'une troisième matière adjacente audit ensemble de magnétrons.

13. Une méthode pour pulvériser un film d'alliage sur un substrat (8), comprenant :
(a) la génération, à l'aide d'un système de pulvérisation selon l'une quelconque des revendications 1 à 12, d'un flux de matières comprenant une première matière et une deuxième matière,
dans laquelle ledit magnétron horizontal contient une cible liquide (1) présentant ladite première matière et fournit un flux (10) de ladite première matière en direction dudit magnétron rotatif, et
dans laquelle ledit magnétron rotatif fait tourner une cible solide (14) présentant ladite deuxième matière par rapport audit magnétron horizontal et fournit un flux (19) desdites première et deuxième matières en direction dudit substrat en vue dudit magnétron rotatif ; et
(b) l'exposition dudit substrat audit flux de matières.

14. La méthode de la revendication 13, dans laquelle ledit substrat est exposé audit flux de matières tandis que ledit substrat est déplacé par rapport audit système de pulvérisation, ou vice versa.
